# EUROPÄISCHE PATENTSCHRIFT

(11) **EP 0 905 170 B1**
(45) Veröffentlichungstag und Bekanntmachung des Hinweises auf die Patenterteilung: **30.10.2013**
(21) Anmeldenummer: 98117334.7
(22) Anmeldetag: 12.09.1998
(51) Int. Cl.: C08G 73/22, C08G 75/32, G03F 7/038

(54) **Polybenzoxazol- und Polybenzothiazol-Vorstufen**
Polybenzoxazoles and polybenzothiazoles precursors
Précurseurs de polybenzoxazoles et de polybenzothiazoles

(30) Priorität: 24.09.1997 DE 19742191
(43) Veröffentlichungstag der Anmeldung: 31.03.1999
(73) Patentinhaber: Qimonda AG, 81739 München (DE)
(72) Erfinder: Sezi, Recai Dr., 91341 Röttenbach (DE); Keitmann, Michael, 91074 Herzogenaurach (DE)
(74) Vertreter: Epping - Hermann - Fischer

(56) Entgegenhaltungen:
- EP-A- 0 733 665
- DE-A- 2 647 004
- DE-A1- 3 716 629
- FR-A- 2 595 362
- CHEMICAL ABSTRACTS, vol. 106, no. 10, 9. März 1987 (1987-03-09) Columbus, Ohio, US; abstract no. 67818y, IGNATENKO ET AL.: "BIS(3-AMINO-4-HYDROXYPHENOXY)PERFLUOROARY LENES AS MONOMERS FOR PRODUCING POLYBENZOXAZOLES WITH HIGHER THERMAL AND HYDROLYTIC STABILITY" XP002088350 & SU 1 205 518 A
- CHEMICAL ABSTRACTS, vol. 120, no. 14, 4 April 1994 (1994-04-04), Columbus, Ohio, US; abstract no.: 164950g, WINZELER ET AL.: "The synthesis of 6F bis(o-aminophenol) monomers by a nucleophilic substitution reaction", XP002088351

## Beschreibung

Die Erfindung betrifft neue Polybenzoxazol- und Polybenzothiazol-Vorstufen sowie diese Vorstufen enthaltende Resistlösungen.

In der Mikroelektronik werden hochwärmebeständige Polymere als Schutz- und Isolierschichten benötigt. Derartige Polymere können als Dielektrikum zwischen zwei Metallebenen eingesetzt werden, beispielsweise bei Multi-Chip-Modulen sowie Speicher-und Logikchips, oder als Pufferschicht ("Buffercoat") zwischen dem Chip und seinem Gehäuse. Einige dieser Polymeren, beispielsweise Vorstufen aromatischer Polyimide (PI) und Polybenzoxazole (PBO), zeigen eine gute Löslichkeit in organischen Lösemitteln sowie gute Filmbildungseigenschaften und können mittels kostengünstiger Schleudertechnik auf die elektronischen Bauteile aufgebracht werden. Die Vorstufen werden dann durch eine Temperaturbehandlung cyclisiert, d.h. in das entsprechende Polymer übergeführt, und erhalten damit ihre endgültigen Eigenschaften.

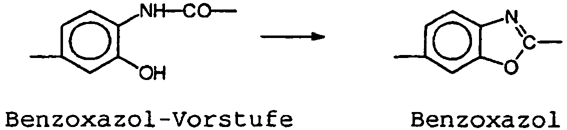

Bei der Cyclisierung verschwinden die polaren, hydrophilen Gruppierungen der PBO-Vorstufe (OH, NH und CO), die sonst die dielektrischen Eigenschaften und die Wasseraufnahme negativ beeinflussen würden. Dies ist beispielsweise ein wesentlicher Vorteil von Polybenzoxazolen gegenüber Polyimiden und insbesondere gegenüber Hydroxypolyimiden. Die Cyclisierung ist aber nicht nur für die guten dielektrischen Eigenschaften und die geringe Wasseraufnahme des Endproduktes wichtig, sondern auch für dessen hohe Temperaturstabilität.

Die Anforderungen an das cyclisierte Endprodukt sind sehr hoch. So ist beispielsweise neben einer möglichst niedrigen Dielektrizitätskonstante und einer hohen thermischen Stabilität insbesondere eine geringe Feuchteaufnahme erforderlich. Die aufgenommene Feuchte beeinträchtigt nämlich nicht nur die elektrischen Eigenschaften, sondern kann auch die Korrosion der metallischen Leiterbahnen fördern oder bei hohen Temperaturen zu Blasenbildungen und Abplatzungen führen.

Polyimide und Polybenzoxazole haben gegenüber vielen anderen hochtemperaturstabilen Polymeren folgende Vorteile:
- Sie können - im Vergleich zum cyclisierten Endprodukt - als lösliche Vorstufe auf ein Substrat aufgebracht und anschließend cyclisiert werden, wobei die Löslichkeit und damit die Sensibilität gegenüber Lösemitteln und anderen Prozeßchemikalien stark abnimmt. Aus diesem Grunde ist beispielsweise die Verarbeitung von vorcyclisierten Polybenzoxazolen schwierig.
- Durch den Zusatz von geeigneten photoaktiven Komponenten zu den Vorstufen können photosensitive Zusammensetzungen hergestellt werden, wodurch eine kostengünstige direkte Strukturierung des Dielektrikums möglich wird. Polybenzoxazole haben gegenüber Polyimiden den weiteren Vorteil, daß sie im positiven Modus strukturierbar und wäßrig-alkalisch entwickelbar sind (siehe EP 0 023 662 B1, EP 0 264 678 B1 und EP 0 291 779 B1). Hierzu müssen die verwendeten PBO-Vorstufen im - vorzugsweise metallionenfreien - alkalischen Entwickler löslich sein.
- Benzocyclobuten (BCB), das in ähnlicher Weise verarbeitet und negativ strukturiert werden kann, hat eine wesentlich geringere Temperaturstabilität als Polyimid und Polybenzoxazol.

Eine weitere, im Zusammenhang mit der kostengünstigen Herstellung von mikroelektronischen Bauteilen wichtige Anforderung ist das Planarisierungvermögen des Dielektrikums. Bei der Herstellung solcher Bauteile entstehen nämlich während der Aufbringung verschiedener Schichten Höhenunterschiede, die eine weitere Prozessierung, beispielsweise die lithographische Erzeugung feiner Strukturen, erschweren. Auf planarisiertem Untergrund können dagegen photolithographische Prozesse mit besserer Maßhaltigkeit und größeren Prozeßtoleranzen durchgeführt werden. Durch die Verwendung eines gut planarisierenden Dielektrikums können bei der Herstellung der Bauteile kostenintensive Schleifprozeduren (Chemical Mechanical Polishing; CMP) vermieden werden.

Alkalilösliche PBO-Vorstufen, die zur Herstellung von photosensitiven Zusammensetzungen geeignet sind, sind beispielsweise aus EP 0 023 662 B1, EP 0 264 678 B1, EP 0 291 779 B1 und DE 37 16 629 C2 bekannt; diese Vorstufen lassen sich auf dem Substrat cyclisieren (siehe dazu EP 0 291 778 B1). Die bekannten Polymeren zeigen jedoch nach der Cyclisierung (Überführung in das Polybenzoxazol) eine relativ hohe Feuchteaufnahme, beispielsweise 1,7 % (siehe EP 0 291 778 B1). Hinweise auf das Planarisierungsvermögen der hergestellten Polymeren gibt es nicht.

Aufgabe der Erfindung ist es, Polybenzoxazol- und Polybenzothiazol-Vorstufen bereitzustellen, die sowohl in organischen Lösemitteln als auch in metallionenfreien wäßrig-alkalischen Entwicklern gut löslich sind, sich gut für photosensitive Zusammensetzungen eignen und mittels Schleudertechnik verarbeitet werden können. Die Vorstufen sollen ferner auf Substraten problemlos cyclisierbar sein und nach der Cyclisierung - neben einer hohen Temperaturstabilität - insbesondere eine sehr geringe Feuchteaufnahme und einen hohen Planarisierungsgrad aufweisen.

Dies wird erfindungsgemäß durch Polybenzoxazol- und Polybenzothiazol-Vorstufen erreicht, die die Partialstruktur gemäß Anspruch 1 enthalten: 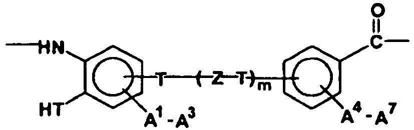 dabei gilt auch folgendes:
für m=1 gilt A¹ bis A⁷ sind - unabhängig voneinander - H, F, CH₃, CF₃, OCH₃, OCF₃, CH₂CH₃, CF₂CF₃, OCH₂CH₃ oder OCF₂CF₃;
T ist O oder S, und m ist 0 oder 1;
Z ist einer der folgenden Reste: 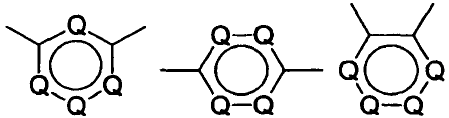 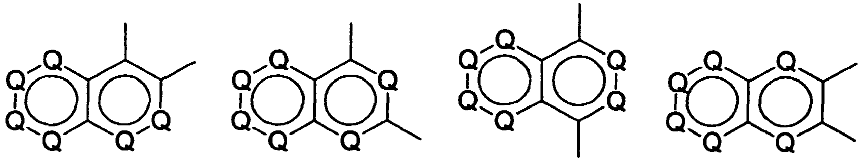 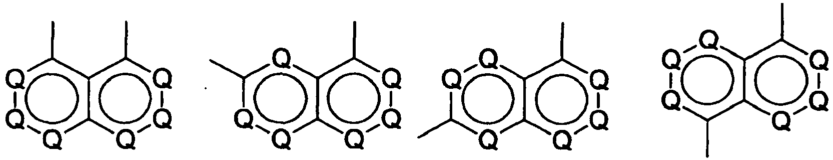 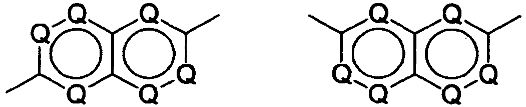 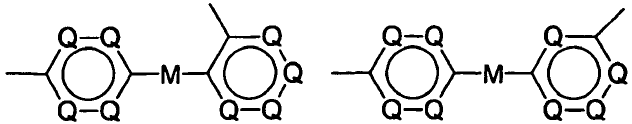 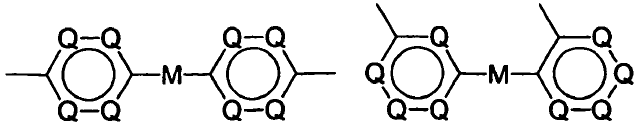 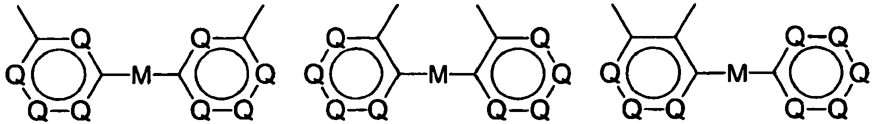 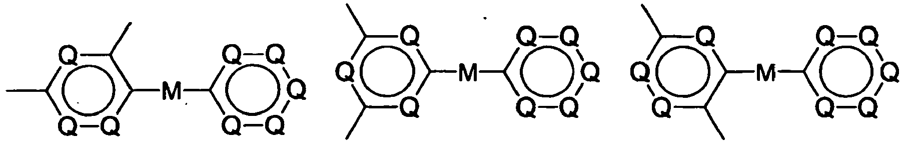 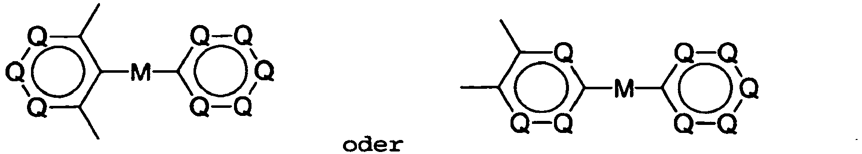
   - mit Q =: C-A oder N,
   mit A = H, F, (CH₂)ₚCH₃, (CF₂)ₚCF₃, O(CH₂)ₚCH₃, O(CF₂)ₚCF₃, CO(CH₂)ₚCH₃, CO(CF₂)ₚCF₃ mit p = 0 bis 8 (Kette linear oder verzweigt), OC(CH₃)₃, OC(CF₃)₃, C₆H₅, C₆F₅, OC₆H₅, OC₆F₅, Cyclopentyl, Perfluorcyclopentyl, Cyclohexyl oder Perfluorcyclohexyl, wobei in den isolierten aromatischen Ringen maximal 3 N-Atome pro Ring vorhanden sein dürfen und nur 2 N-Atome benachbart sein können und in den anellierten Ringsystemen maximal 2 N-Atome pro Ring vorhanden sein dürfen,
   - M =: eine Einfachbindung, geradkettige Alkylen-Gruppe, geradkettige perfluorierte Alkylen-Gruppe, CH(CH₃), CH(CF₃), CF(CH₃), CF(CF₃), C(CH₃)₂, C(CF₃)₂, CH(C₆H₅), CH(C₆F₅), CF(C₆H₅), CF(C₆F₅), C(CH₃)(C₆H₅), C(CH₃)(C₆F₅), C(CF₃)(C₆H₅), C(CF₃)(C₆F₅), C(C₆H₅)₂, C(C₆F₅)₂, CO, SO₂, 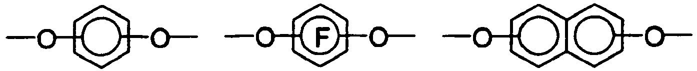 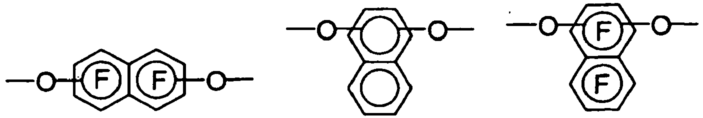 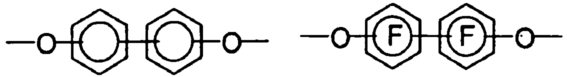 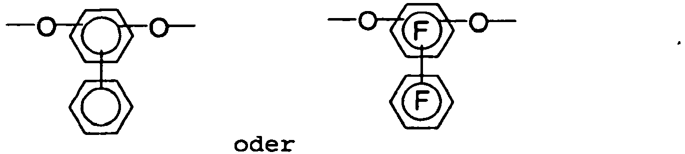
mit der Maßgabe, daß bei Z = Phenylen (dies sind die ersten drei der vorstehend bei Z aufgeführten Reste mit Q = C-A) mindestens einer der Reste A¹ bis A⁷ ≠ H sein muß.

Polymer-Vorstufen der vorstehend angegebenen Struktur werden durch Polymerisation von entsprechenden o-Aminophenol-carbonsäuren bzw. o-Aminothiophenol-carbonsäuren hergestellt. Dabei wird die o-Aminophenol-carbonsäure bzw. die o-Aminothiophenol-carbonsäure in einem organischen Lösemittel bei einer Temperatur von 25 bis 130°C in Gegenwart eines geeigneten Polymerisationsagens polymerisiert. Das Agens ist beispielsweise Triphenylphosphit, das in einer äquimolaren Menge eingesetzt wird. Der Reaktionslösung kann vorteilhaft eine Base, wie Pyridin, und Lithium- oder Calciumchlorid zugesetzt werden (siehe dazu: "Macromolecules", Vol. 18 (1985), Seiten 616 bis 622). Es ist aber auch möglich, die Polymerisation in Gegenwart von Triphenylphosphin (siehe DE 37 16 629 C2) oder Oxalylchlorid durchzuführen. Das entstandene Polymer wird dann durch Zutropfen der Reaktionslösung zu einem geeigneten Fällungsmittel ausgefällt. Das ausgefallene Polymer ist bereits nach der Filtration und der Trocknung einsatzbereit.

Die zur Herstellung der Polybenzoxazol- und Polybenzothiazol-Vorstufen nach der Erfindung eingesetzten o-Aminophenol-carbonsäuren und o-Aminothiophenol-carbonsäuren weisen folgende Struktur auf:

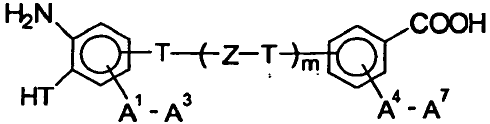

Im übrigen bedeutet die Charakterisierung "A¹-A³" und "A⁴-A⁷" in der Strukturformel, daß die Aminophenylgruppen Reste A¹, A² und A³ bzw. A⁴, A⁵, A⁶ und A⁷ aufweisen.

Beispiele für derartige o-Aminophenol-carbonsäuren sind:
4-(4-Amino-3-hydroxy-phenoxy)-4'-(4-carboxy-phenoxy)-octafluorbiphenyl 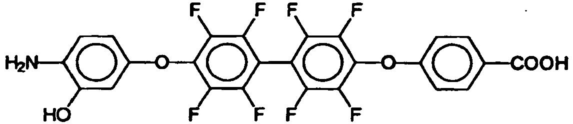
4-(4-Amino-3-hydroxy-phenoxy)-2-(4-carboxy-phenoxy)-3,5,6-trifluorpyridin 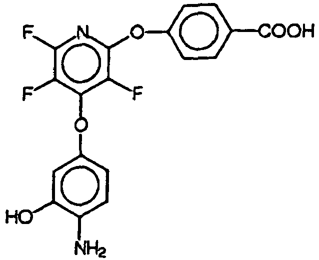
4-(4-Amino-3-hydroxy-phenoxy)-2-(4-carboxy-phenoxy)-1-trifluormethyl-3,5,6-trifluorbenzol 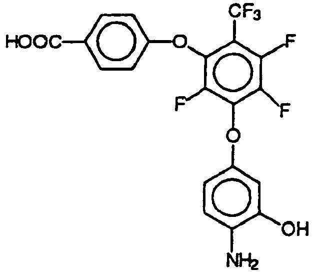
4-(4-Amino-3-hydroxy-2,5,6-trifluor-phenoxy)-benzoesäure 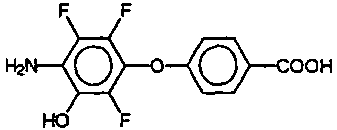
4-(4-Amino-3-hydroxy-2,5,6-trifluor-phenoxy)-4'-(4-carboxy²phenoxy)-octafluorbiphenyl 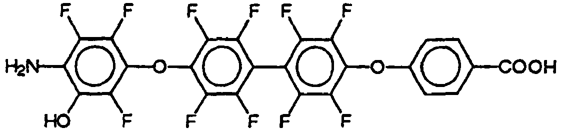
4-(4-Amino-3-hydroxy-2,5,6-trifluor-phenoxy)-2-(4-carboxyphenoxy)-3,5,6-trifluorpyridin

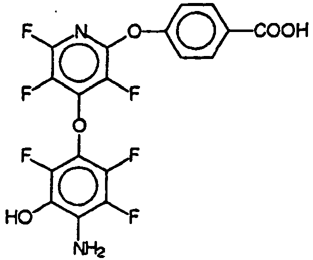

Besonders geeignete Lösemittel für die Polymersynthese sind Dimethylacetamid, γ-Butyrolacton und N-Methylpyrrolidon. Prinzipiell kann jedoch jedes Lösemittel verwendet werden, in dem die Ausgangskomponenten gut löslich sind. Besonders geeignete Fällungsmittel sind Wasser und Gemische von Wasser mit verschiedenen Alkoholen, beispielsweise Ethanol und Isopropanol.

Die Polymer-Vorstufen nach der Erfindung sind in vielen organischen Lösemitteln, wie Aceton, Cyclohexanon, Diethylenglykolmono- bzw. -diethylether, N-Methylpyrrolidon, γ-Butyrolacton, Ethyllactat, Tetrahydrofuran und Essigsäureethylester, sowie in metallionenfreien wäßrig-alkalischen Entwicklern gut löslich und lassen sich mittels Schleudertechnik problemlos verarbeiten. Nach der Cyclisierung auf dem Substrat zeigen die dabei erhaltenen Polybenzoxazole und Polybenzothiazole eine sehr geringe Feuchteaufnahme, einen hohen Planarisierungsgrad und eine hohe Temperaturstabilität.

Die Polymer-Vorstufen nach der Erfindung sind mit Diazoketonen verträglich und eignen sich deshalb vorteilhaft für Photoresistlösungen, die - gelöst in einem Lösemittel - eine Polybenzoxazol- oder Polybenzothiazol-Vorstufe und eine photoaktive Komponente auf Diazoketonbasis aufweisen. Derartige photoaktive Zusammensetzungen zeigen überraschenderweise eine hohe Auflösung und eine sehr gute Filmqualität. In den Photoresistlösungen liegt das Gewichtsverhältnis von Polybenzoxazol- bzw. Polybenzothiazol-Vorstufe zu Diazochinon vorteilhaft zwischen 1:20 und 20:1, vorzugsweise zwischen 1:10 und 10:1.

Anhand von Ausführungsbeispielen soll die Erfindung noch näher erläutert werden.

### Beispiel 1

### Herstellung einer o-Aminophenol-carbonsäure:

### 4-(4-Amino-3-hydroxy-phenoxy)-4'-(4-carboxy-phenoxy)-octafluorbiphenyl

37,4 g Decafluorbiphenyl (0,112 mol) werden in 700 ml Dimethylformamid gelöst und mittels eines Kryostaten auf -10°C abgekühlt, dann wird innerhalb von 2 h eine Lösung von 29,8 g Kalium-4-benzyloxycarbonylphenolat (0,112 mol) in 300 ml Dimethylformamid zugetropft. Nach 48 h bei -10°C ist das Kaliumsalz umgesetzt. Dann wird das Dimethylformamid in einem Rotationsverdampfer entfernt, der Rückstand in wenig Tetrahydrofuran aufgenommen und über eine Kieselgelsäule filtriert. Die erhaltene klare Lösung wird im Rotationsverdampfer eingeengt, bis ein weißer Feststoff ausfällt. Der Feststoff wird dann in n-Hexan gerührt, über ein Faltenfilter abfiltriert und anschließend in einem Vakuumschrank 48 h unter Stickstoff bei 40°C/10 mbar getrocknet.

49,9 g des auf diese Weise hergestellten 4-(4-Benzyloxycarbonyl-phenoxy)-nonafluorbiphenyl (0,092 mol) und 26,1 g Kalium-4-nitro-3-benzyloxy-phenolat (0,092 mol) werden in 400 ml Dimethylformamid gelöst, und die Lösung wird auf 80°C erhitzt; nach 24 h ist die Reaktion vollständig abgelaufen.

Dann wird das Lösemittel in einem Rotationsverdampfer entfernt. Der erhaltene feste Rückstand wird dreimal mit Methanol gewaschen, über einen Büchnertrichter abfiltriert und anschließend in einem Vakuumschrank 48 h unter Stickstoff bei 40°C/10 mbar getrocknet.

49,9 g des auf diese Weise hergestellten 4-(4-Nitro-3-benzyloxy-phenoxy)-4'-(4-benzyloxycarbonyl-phenoxy)-octafluorbiphenyl (0,065 mol) werden in 400 ml eines Gemisches von Tetrahydrofuran und Essigsäureethylester (Volumenverhältnis 1:1) gelöst, und zu der Lösung werden 5 g Pd/C (Palladium/ Kohlenstoff) gegeben. Dann wird bei Raumtemperatur in einem Autoklaven unter starkem Rühren mit Wasserstoff bei einem Druck von 1 bar hydriert; nach 3 Tagen wird die Reaktion beendet. Die gelbbeige Lösung wird in einem Rotationsverdampfer auf die Hälfte eingeengt und über Nacht bei Raumtemperatur stehengelassen; dabei fällt das Reaktionsprodukt kristallin aus. Anschließend wird das Reaktionsprodukt abgetrennt und in einem Vakuumschrank 48 h unter Stickstoff bei 40°C/10 mbar getrocknet.

### Beispiel 2

### Herstellung einer PBO-Vorstufe

55,7 g entsprechend Beispiel 1 hergestelltes 4-(4-Amino-3-hydroxy-phenoxy)-4'-(4-carboxy-phenoxy)-octafluorbiphenyl (0,1 mol) werden in 370 ml destilliertem N-Methylpyrrolidon gelöst. Zu dieser Lösung tropft man bei 0°C langsam eine Lösung von 13 g Oxalylchlorid (0,102 mol) in 85 ml γ-Butyrolacton. Nach der Zugabe wird noch 2 h bei 0°C und 18 h bei Rumtemperatur gerührt. Anschließend gibt man - zur vollständigen Umsetzung - bei 0°C eine Lösung von 20 ml Pyridin in 100 ml N-Methylpyrrolidon hinzu und rührt weitere 24 h bei Raumtemperatur. Die gelbbraune Lösung wird dann über einen Büchnertrichter filtriert und unter starkem Rühren zu einem Gemisch von Isopropanol und Wasser (1:3) getropft. Die Menge des Fällungsmittels (Isopropanaol/Wasser) wird dabei so gewählt, daß sie dem 10fachen der Reaktionslöung entspricht. Das ausgefallene Polymer wird über einen Büchnertrichter abfiltriert und dreimal mit einer 1 %igen Ammoniaklösung gewaschen. Nach der Reinigung wird das Polymer in einem Vakuumschrank 72 h unter Stickstoff bei 40°C/10 mbar getrocknet.

Die auf diese Weise hergestellte PBO-Vorstufe ist in Lösemitteln wie N-Methylpyrrolidon, γ-Butyrolacton, Aceton, Tetrahydrofuran, Cyclopentanon, Diethylenglykolmonoethylether, Ethyllactat und Ethanol sowie in kommerziell erhältlichen metallionenfreien wäßrig-alkalischen Entwicklern, wie NMD-W (Tokyo Ohka), gut löslich.

### Beispiel 3

### Bestimmung der Feuchteaufnahme

4 g der PBO-Vorstufe nach Beispiel 2 werden in 12 g destilliertem N-Methylpyrrolidon gelöst. Die Lösung wird mittels einer mit einem Vorfilter versehenen Plastikspritze auf ein Substrat in Form einer gereinigten, getrockneten und genau abgewogenen Siliziumscheibe (Wafer) aufgetragen und in einer Schleuderapparatur (Typ ST 146, Convac) geschleudert. Der auf dem Substrat entstandene Film wird zunächst auf einer Heizplatte bei 120°C vorgetrocknet und anschließend - für die Cyclisierung (auf dem Substrat) - in einem programmierbaren Laborofen ("Sirius Junior", LP-Thermtech AG) unter Stickstoff auf 350°C aufgeheizt und bei dieser Temperatur 1 h getempert; dann wird abgekühlt. Die Aufheiz- und Abkühlgeschwindigkeit beträgt jeweils 5°C/min.

Das beschichtete Substrat wird in eine tarierte Mikrowaage (Typ AT 261 Deltarange, Mettler Toledo) mit einer abgedichteten Kammer gestellt, in der sich Phosphorpentoxid als Trocknungsmittel befindet. Das nach 24 h ermittelte Gesamtgewicht beträgt 11,24863 g. Hieraus ergibt sich für das cyclisierte Polymer ein Gewicht von 0,16321 g (Gewicht der reinen Siliziumscheibe 11,08542 g). Das Phosphorpentoxid wird dann durch eine gesättigte Natriumchlorid-Lösung ersetzt und in der Kammer eine relative Feuchtigkeit (23°C) von 76 % eingestellt. Nach weiteren 24 h Lagerung erhöht sich das Gewicht des Films auf 0,16424 g. Hieraus ergibt sich eine Feuchteaufnahme von 0,63 %. Eine nicht-beschichtete Siliziumscheibe zeigt unter gleichen Bedingungen keine Feuchteaufnahme.

### Beispiel 4

### Bestimmung des Planarisierungsgrades

Das Planarisierungsvermögen von aus den Vorstufen nach der Erfindung durch Cyclisierung auf einem Substrat hergestellten Polybenzoxazolen wird an Siliziumwafern mit 1,2 µm hohen Aluminiumstrukturen (Planarisierungswafer) bestimmt. Der Planarisierungsgrad ist für die periodischen 5 µm-Strukturen (= Linien- und Grabenbreite; alternierend) angegeben. Die Bestimmung des Planarisierungsgrades erfolgt nach D.S. Soane und Z. Martynenko: "Polymers in Microelectronics - Fundamentals and Applications", Elsevier Science Publishers B.V., Amsterdam 1989, Seiten 189 bis 191.

Die PBO-Vorstufe nach Beispiel 2 wird - wie in Beispiel 3 - auf einen Planarisierungswafer (Substrat) aufgebracht und cyclisiert. Der cyclisierte Film weist eine Dicke von 2,0 µm auf; der Planarisierungsgrad beträgt 75 %.

### Beispiel 5

### Photostrukturierung

4 g der PBO-Vorstufe nach Beispiel 2 werden zusammen mit 1 g eines Diesters aus Bisphenol A und Naphthochinondiazid-5-sulfonsäure (photoaktive Komponente) in 15 g N-Methylpyrrolidon gelöst. Diese Photoresistlösung wird mittels einer mit einem Vorfilter versehenen Plastikspritze auf ein Substrat in Form einer gereinigten und getrockneten Siliciumscheibe (Wafer) aufgetragen und in einer Schleuderapparatur (Typ ST 146, Convac) geschleudert. Der auf dem Substrat entstandene Resistfilm wird zunächst auf einer Heizplatte bei 120°C vorgetrocknet und anschließend in einer Belichtungsapparatur (Typ 121, Karl Süss) durch eine Maske belichtet. Nach der Entwicklung mit einem wäßrig-alkalischen Entwickler (NMD-W, Tokyo Ohka, 1:1 mit Wasser verdünnt) und der Cyclisierung (auf dem Substrat) bei 350°C entsprechend Beispiel 3 werden hochtemperaturstabile Resiststrukturen mit einer Auflösung von 2 µm bei einer Schichtdicke von 2 µm erhalten.

### Beispiel 6

### Herstellung einer PBO-Vorstufe und Bestimmung der Eigenschaften

Analog zu Beispiel 2 wird eine PBO-Vorstufe hergestellt, wobei - unter sonst gleichen Bedingungen - als o-Aminophenol-carbonsäure 4-(4-Amino-3-hydroxy-phenoxy)-2-(4-carboxyphenoxy)-3,5,6-trifluorpyridin (0,1 mol, d.h. 39,2 g) eingesetzt wird. Die o-Aminophenol-carbonsäure wird - analog Beispiel 1 - aus Pentafluorpyridin, Kalium-4-benzyloxycarbonylphenolat und Kalium-4-nitro-3-benzyloxy-phenolat hergestellt.

Die erhaltene PBO-Vorstufe ist in den in Beispiel 2 aufgeführten Lösemitteln gut löslich. Bei dieser Vorstufe wird eine Feuchteaufnahme von 0,75 % (siehe Beispiel 3) und ein Planarisierungsgrad von 77 % (siehe Beispiel 4) ermittelt. Nach der entsprechend Beispiel 5 durchgeführten Photostrukturierung und Cyclisierung auf dem Substrat werden hochtemperaturstabile Resiststrukturen mit einer Auflösung von 2 µm bei einer Schichtdicke von 1,9 µm erhalten.

### Beispiel 7

### Herstellung einer PBO-Vorstufe und Bestimmung der Eigenschaften

Analog zu Beispiel 2 wird eine PBO-Vorstufe hergestellt, wobei - unter sonst gleichen Bedingungen - als o-Aminophenol-carbonsäure 4-(4-Amino-3-hydroxy-phenoxy)-2-(4-carboxy-phenoxy)-1-trifluormethyl-3,5,6-trifluorbenzol (0,1 mol, d.h. 45,9 g) eingesetzt wird. Die o-Aminophenol-carbonsäure wird - analog Beispiel 1 - aus Octafluortoluol, Kalium-4-benzyloxycarbonylphenolat und Kalium-4-nitro-3-benzyloxy-phenolat hergestellt.

Die erhaltene PBO-Vorstufe ist in den in Beispiel 2 aufgeführten Lösemitteln gut löslich. Bei dieser Vorstufe wird eine Feuchteaufnahme von 0,71 % (siehe Beispiel 3) und ein Planarisierungsgrad von 82 % (siehe Beispiel 4) ermittelt. Nach der entsprechend Beispiel 6 durchgeführten Photostrukturierung und Cyclisierung auf dem Substrat werden hochtemperaturstabile Resiststrukturen mit einer Auflösung von 2 µm bei einer Schichtdicke von 2,1 µm erhalten.

### Beispiel 8

### Herstellung einer PBO-Vorstufe und Bestimmung der Eigenschaften

Analog zu Beispiel 2 wird eine PBO-Vorstufe hergestellt, wobei - unter sonst gleichen Bedingungen - als o-Aminophenol-carbonsäure 4-(4-Amino-3-hydroxy-2,5,6-trifluor-phenoxy)-benzoesäure (0,1 mol, d.h. 29,9 g) eingesetzt wird. Die o-Aminophenolcarbonsäure wird - über 4-(4-Nitro-3-hydroxy-2,5,6-trifluor-phenoxy)-benzoesäurebenzylester - aus Pentafluor-nitrobenzol und 4-Hydroxybenzoesäurebenzylester hergestellt (siehe Beispiel 1).

Die erhaltene PBO-Vorstufe ist in den in Beispiel 2 aufgeführten Lösemitteln gut löslich. Bei dieser Vorstufe wird eine Feuchteaufnahme von 0,71 % (siehe Beispiel 3) und ein Planarisierungsgrad von 83 % (siehe Beispiel 4) ermittelt. Nach der entsprechend Beispiel 6 durchgeführten Photostrukturierung und Cyclisierung auf dem Substrat werden hochtemperaturstabile Resiststrukturen mit einer Auflösung von 2 µm bei einer Schichtdicke von 2,2 µm erhalten.

### Beispiel 9

### Herstellung einer PBO-Vorstufe und Bestimmung der Eigenschaften

Analog zu Beispiel 2 wird eine PBO-Vorstufe hergestellt, wobei - unter sonst gleichen Bedingungen - als o-Aminophenol-carbonsäure 4-(4-Amino-3-hydroxy-2,5,6-trifluor-phenoxy)-4'-(4-carboxy-phenoxy)-octafluorbiphenyl (0,1 mol, d.h. 61,1 g) eingesetzt wird. Die o-Aminophenol-carbonsäure wird über 4-(4-Nitro-3-hydroxy-2,5,6-trifluor-phenoxy)-4'-(4-benzyloxycarbonyl-phenoxy)-octafluorbiphenyl hergestellt (siehe dazu Beispiel 1), das durch Umsetzung von 4-(4-Benzyloxycarbonyl-phenoxy)-nonafluorbiphenyl, hergestellt aus Decafluorbiphenyl und Kalium-4-benzyloxycarbonylphenolat, mit 4-Nitro-tetrafluorphenol erhalten wird.

Die erhaltene PBO-Vorstufe ist in den in Beispiel 2 aufgeführten Lösemitteln gut löslich. Bei dieser Vorstufe wird eine Feuchteaufnahme von 0,61 % (siehe Beispiel 3) und ein Planarisierungsgrad von 74 % (siehe Beispiel 4) ermittelt. Nach der entsprechend Beispiel 6 durchgeführten Photostrukturierung und Cyclisierung auf dem Substrat werden hochtemperaturstabile Resiststrukturen mit einer Auflösung von 2 µm bei einer Schichtdicke von 1,8 µm erhalten.

### Beispiel 10

### Herstellung einer PBO-Vorstufe und Bestimmung der Eigenschaften

Analog zu Beispiel 2 wird eine PBO-Vorstufe hergestellt, wobei - unter sonst gleichen Bedingungen - als o-Aminophenol-carbonsäure 4-(4-Amino-3-hydroxy-2,5,6-trifluor-phenoxy)-2-(4-carboxy-phenoxy)-3,5,6-trifluorpyridin (0,1 mol, d.h. 44,6 g) eingesetzt wird. Die o-Aminophenol-carbonsäure wird über 4-(4-Nitro-3-hydroxy-2,5,6-trifluor-phenoxy)-2-(4-benzyloxycarbonyl-phenoxy)-3,5,6-trifluorpyridin hergestellt (siehe dazu Beispiel 1), das durch Umsetzung von 2-(4-Benzyloxycarbonyl-phenoxy)-3,4,5,6-tetrafluorpyridin, hergestellt aus Pentafluorpyridin und Kalium-4-benzyloxycarbonylphenolat, mit 4-Nitro-tetrafluorphenol erhalten wird.

Die erhaltene PBO-Vorstufe ist in den in Beispiel 2 aufgeführten Lösemitteln gut löslich. Bei dieser Vorstufe wird eine Feuchteaufnahme von 0,73 % (siehe Beispiel 3) und ein Planarisierungsgrad von 75 % (siehe Beispiel 4) ermittelt.

Nach der entsprechend Beispiel 6 durchgeführten Photostrukturierung und Cyclisierung auf dem Substrat werden hochtemperaturstabile Resiststrukturen mit einer Auflösung von 2 µm bei einer Schichtdicke von 2 µm erhalten.

## Patentansprüche

1. Polybenzoxazol- und Polybenzothiazol-Vorstufen, g e - k e n n z e i c h n e t durch folgende Partialstruktur: 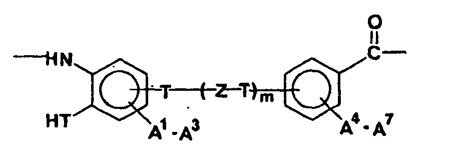 wobei folgendes gilt:
für m = 1 gilt A¹ bis A⁷ sind - unabhängig voneinander - H, F, CH₃, CF₃, OCH₃, OCF₃, CH₂CH₃, CF₂CF₃, OCH₂CH₃ oder OCF₂CF₃;
für m = 0 gilt A¹ = F, CF₃, OCH₃, OCF₃, CF₂CF₃, OCH₂CH₃ oder OCF₂CF₃ und A² bis A⁷ sind - unabhängig voneinander - H, F, CH₃, CF₃, OCH₃, OCF₃, CH₂CH₃, CF₂CF₃, OCH₂CH₃ oder OCF₂CF₃;
T ist O oder S;
Z ist einer der folgenden Reste: 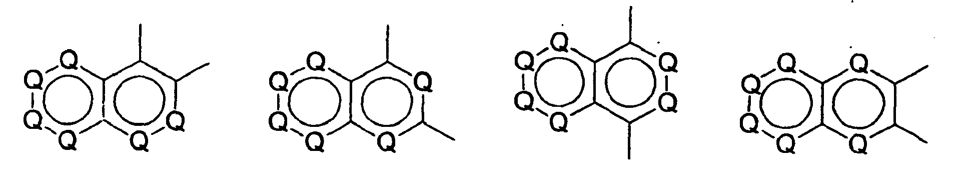 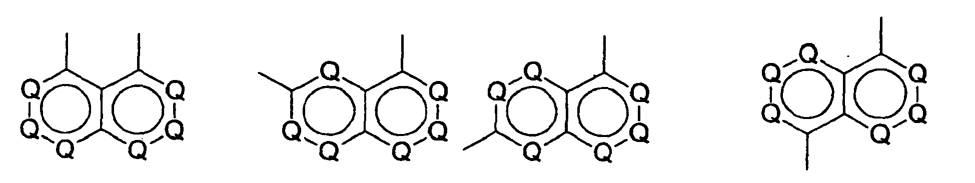 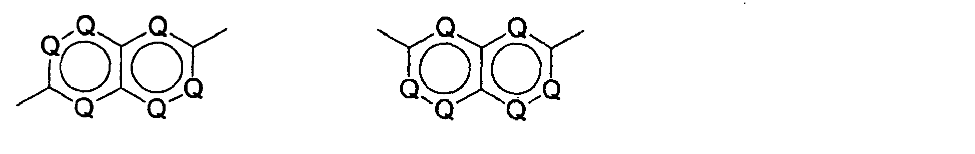 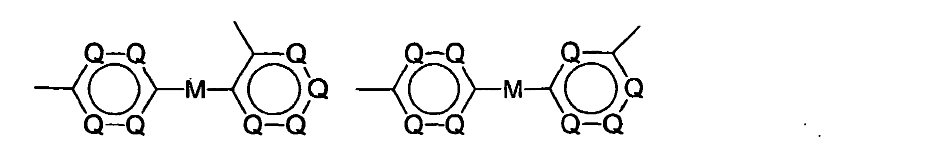 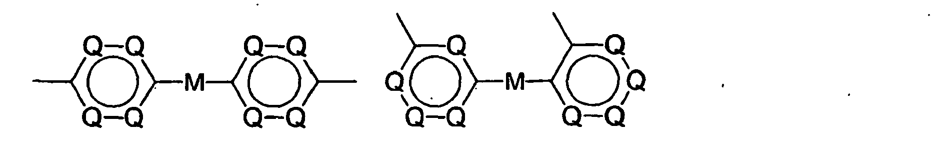 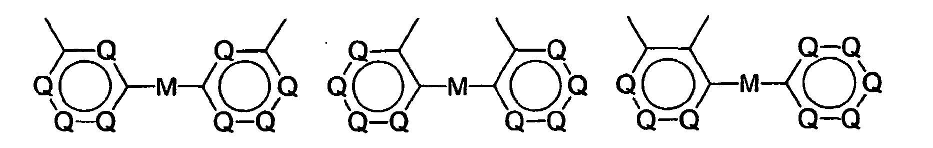 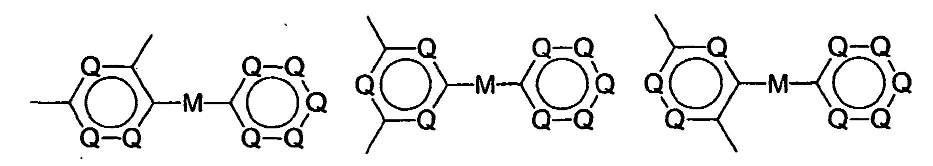 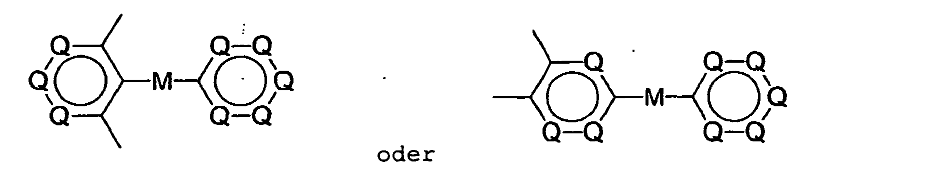
mit Q = C-A oder N,
mit A = H, F, (CH₂)ₚCH₃, (CF₂)ₚCF₃, O(CH₂)ₚCH₃, O(CF₂)ₚCF₃, CO(CH₂)ₚCH₃, CO(CF₂)ₚCF₃ mit p = 0 bis 8 (Kette linear oder verzweigt), OC(CH₃)₃, OC(CF₃)₃, C₆H₅, C₆F₅, OC₆H₅, OC₆F₅, Cyclopentyl, Perfluorcyclopentyl, Cyclohexyl oder Perfluorcyclohexyl,
wobei in den isolierten aromatischen Ringen maximal 3 N-Atome pro Ring vorhanden sein dürfen und nur 2 N-Atome benachbart sein können und in den anellierten Ringsystemen maximal 2 N-Atome pro Ring vorhanden sein dürfen, oder Z ist 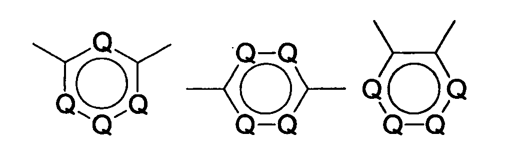
mit Q = C-A oder N,
mit A = F, (CH₂)ₚCH₃, (CF₂)ₚCF₃, O(CH₂)ₚCH₃, O(CF₂)ₚCF₃, CO(CH₂)ₚCH₃, CO(CF₂)ₚCF₃ mit p = 0 bis 8 (Kette linear oder verzweigt), OC(CH₃)₃, OC(CF₃)₃, C₆H₅, C₆F₅, OC₆H₅, OC₆F₅, Cyclopentyl, Perfluorcyclopentyl, Cyclohexyl oder Perfluorcyclohexyl,
wobei maximal 3 N-Atome pro Ring vorhanden sein dürfen und nur 2 N-Atome benachbart sein können,
M = eine Einfachbindung, geradkettige Alkylen-Gruppe, geradkettige perfluorierte Alkylen-Gruppe, CH(CH₃), CH(CF₃), CF(CH₃), CF(CF₃), C(CH₃)₂, C(CF₃)₂, CH(C₆H₅), CH(C₆F₅), CF(C₆H₅), CF(C₆F₅), C(CH₃)(C₆H₅), C (CH₃)(C₆F₅), C(CF₃)(C₆H₅), C (CF₃)(C₆F₅), C (C₆H₅)₂, C(C₆F₅)₂, CO, SO₂, 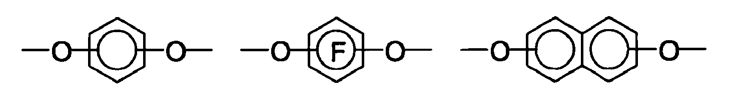 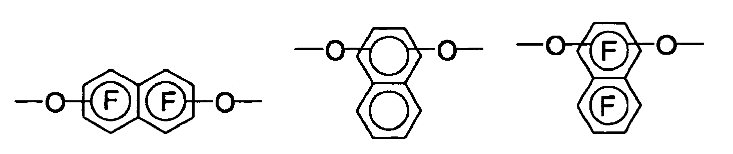 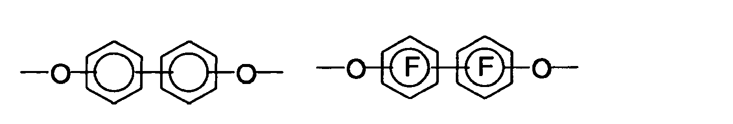 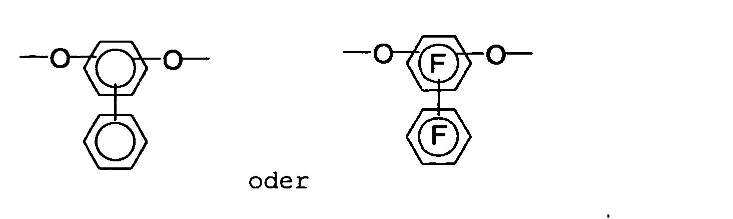
mit der Maßgabe, daß bei Z = Phenylen mindestens einer der Reste A¹ bis A⁷ ≠ H sein muß.

2. Photoresistlösungen, **dadurch gekenn** - **zeichnet** , daß sie eine Polybenzoxazol- oder Polybenzothiazol-Vorstufe nach Anspruch 1 und ein Diazoketon als photoaktive Komponente, gelöst in einem organischen Lösemittel, enthalten.

3. Photoresistlösungen nach Anspruch 2, **dadurch gekennzeichnet , daß** das Gewichtsverhältnis von Polybenzoxazol- bzw. Polybenzothiazol-Vorstufe zu Diazochinon als Diazoketon zwischen 1:20 und 20:1 liegt, vorzugsweise zwischen 1:10 und 10:1.

## Claims

1. Polybenzoxazole and polybenzothiazole precursors, **characterized by** the following partial structure: 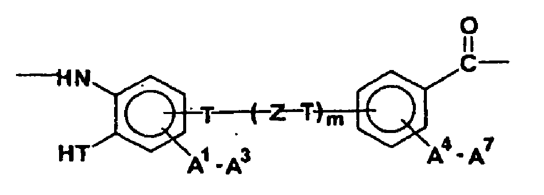 with the following requirements:
for m = 1 applies: A¹ to A⁷ are - independently of one another - H, F, CH₃, CF₃, OCH₃, OCF₃, CH₂CH₃, CF₂CF₃, OCH₂CH₃ or OCF₂CF₃;
for m = 0 applies : A¹ = F, CF₃, OCH₃, OCF₃, CF₂CF₃, OCH₂CH₃ or OCF₂CF₃ and A² to A⁷ are - independently of one another - H, F, CH₃, CF₃, OCH₃, OCF₃, CH₂CH₃, CF₂CF₃, OCH₂CH₃ or OCF₂CF₃;
T is 0 or S;
Z is one of the following residues: 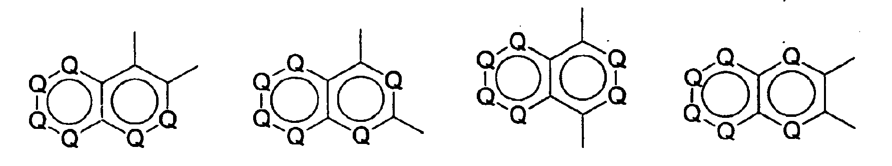 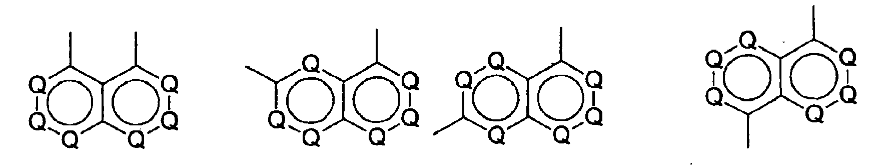 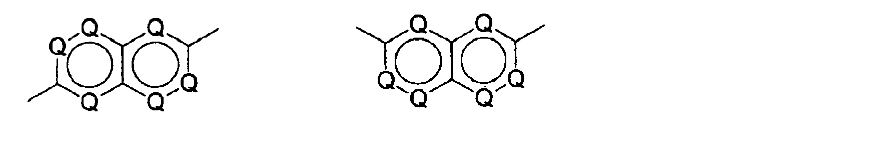 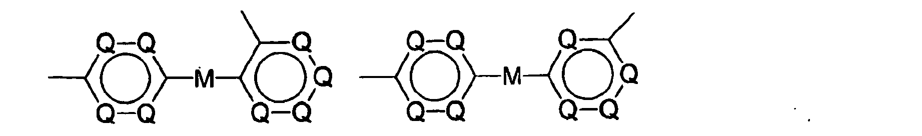 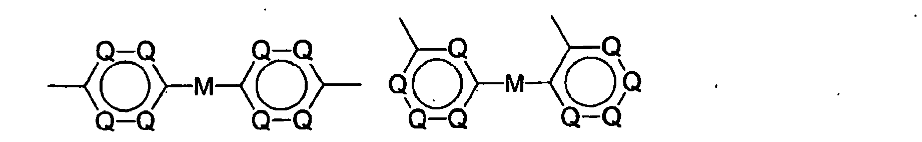 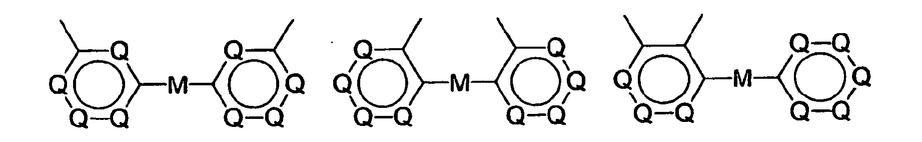 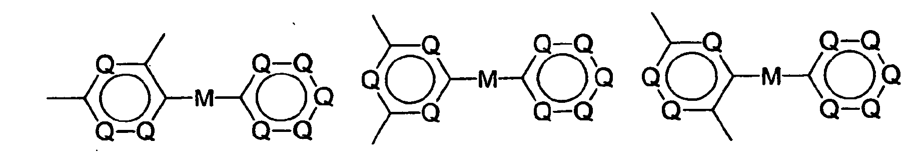 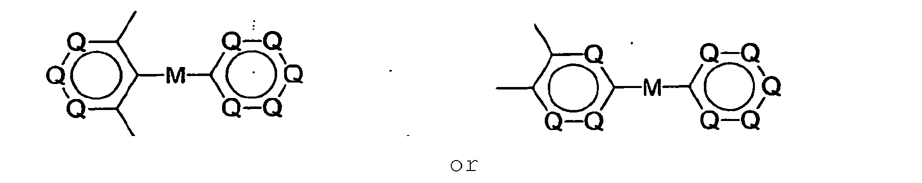
with Q = C-A or N,
with A = H, F, (CH₂)ₚCH₃, (CF₂)ₚCF₃, O(CH₂)ₚCH₃, O(CF₂)ₚCF₃, CO(CH₂)ₚCH₃, CO(CF₂)ₚCF₃ with p = 0 to 8 (chain linear or branched), OC(CH₃)₃, OC(CF₃)₃, C₆H₅, C₆F₅, OC₆H₅, OC₆F₅, cyclopentyl, perfluorocyclopentyl, cyclohexyl or perfluorocyclohexyl,
where a maximum number of 3 nitrogen atoms per ring may be present in the isolated aromatic rings and only two nitrogen atoms can be adjacent and a maximum number of 2 nitrogen atoms per ring may be present in the annelated ring systems, or Z is 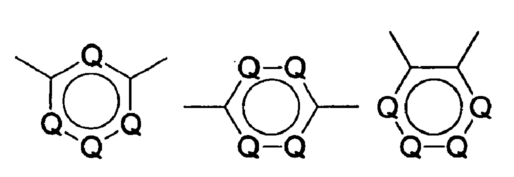 with Q = C-A or N,
with A = F, (CH₂)ₚCH₃, (CF₂)ₚCF₃, O(CH₂)ₚCH₃, O(CF₂)ₚCF₃, CO(CH₂)ₚCH₃, CO(CF₂)ₚCF₃ with p = 0 to 8 (chain linear or branched), OC(CH₃)₃, OC(CF₃)₃, C₆H₅, C₆F₅, OC₆H₅, OC₆F₅, cyclopentyl, perfluorocyclopentyl, cyclohexyl or perfluorocyclohexyl,
where a maximum number of 3 nitrogen atoms may be present per ring and only two nitrogen atoms can be adjacent,
M = a single bond, a straight-chain alkylene group, a straight-chain perfluorinated alkylene group, CH(CH₃), CH(CF₃), CF(CH₃), CF(CF₃), C(CH₃)₂, C(CF₃)₂, CH(C₆H₅), CH(C₆F₅), CF(C₆H₅), CF(C₆F₅), C(CH₃) (C₆H₅), C(CH₃) (C₆F₅), C(CF₃) (C₆H₅), C(CF₃) (C₆F₅), C(C₆H₅)₂, C(C₆F₅)₂, CO, SO₂, 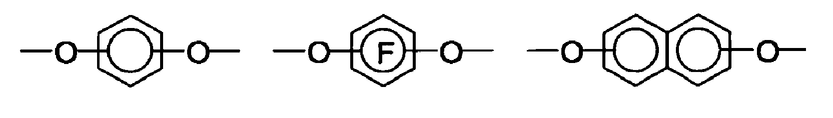 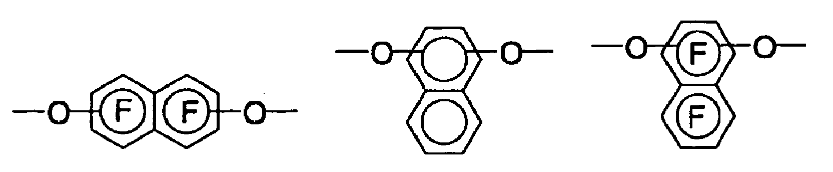 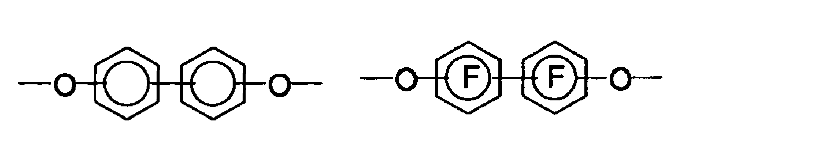 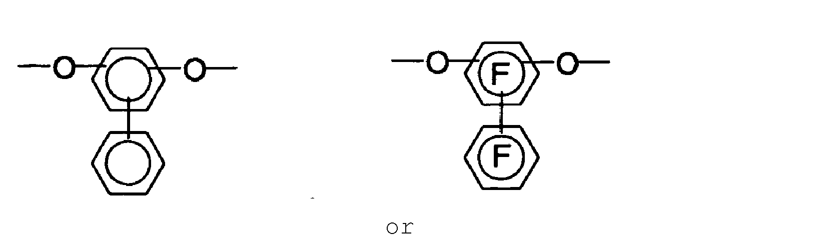 with the condition that at least one of the residues A¹ to A⁷ must not be H if Z = phenylene.

2. Photoresist solutions, **characterized in that** they comprise a polybenzoxazole or polybenzothiazole precursor according to claim 1 and a diazoketone as a photoactive component, dissolved in an organic solvent.

3. The photoresist solutions according to claim 2, **characterized in that** the weight ratio of the polybenzoxazole or polybenzothiazole precursor to diazochinone as a diazoketone is between 1:20 and 20:1, preferably between 1:10 and 10:1.

## Revendications

1. Précurseurs de polybenzoxazoles et de polybenzothiazoles,
**caractérisés par** la structure partielle suivante : 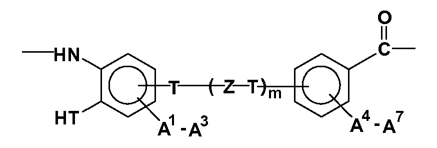 dans laquelle on a :
pour m = 1, on a A¹ à A⁷ sont - indépendamment les uns des autres - H, F, CH₃, CF₃, OCH₃, OCF₃, CH₂CH₃, CF₂CF₃, OCH₂CH₃ ou OCF₂CF₃ ;
pour m = 0, on a A¹ = F, CF₃, OCH₃, OCF₃, CF₂CF₃, OCH₂CH₃ ou OCF₂CF₃ et A² à A⁷ sont - indépendamment les uns des autres - H, F, CH₃, CF₃, OCH₃, OCF₃, CH₂CH₃, CF₂CF₃, OCH₂CH₃ ou OCF₂CF₃ ;
T est 0 ou S ;
Z est l'un des restes suivants : 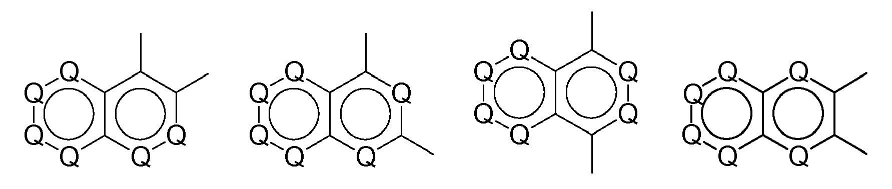 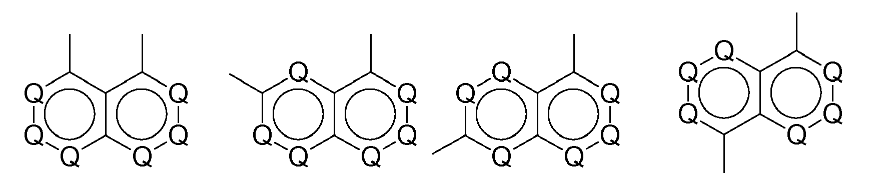 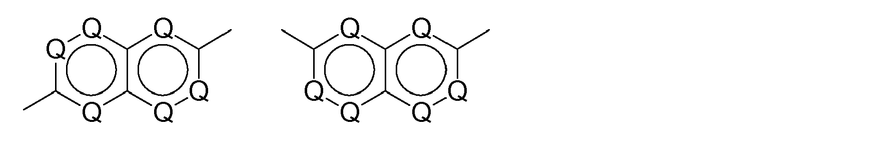 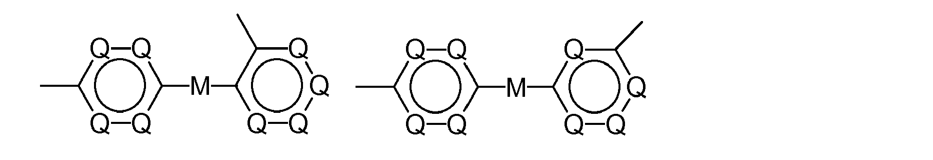 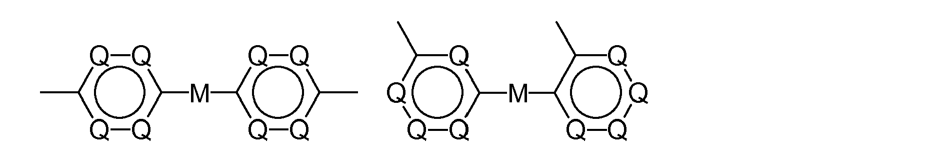 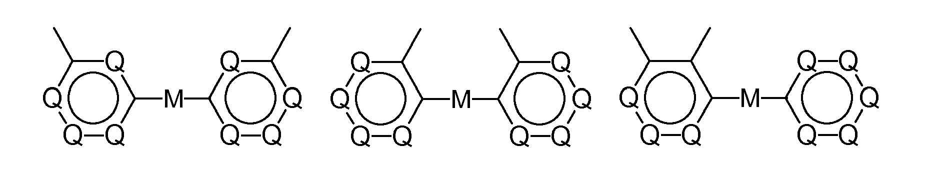 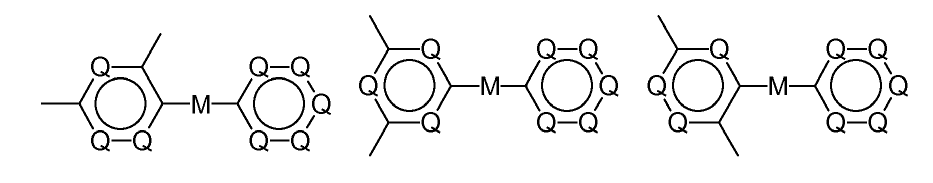 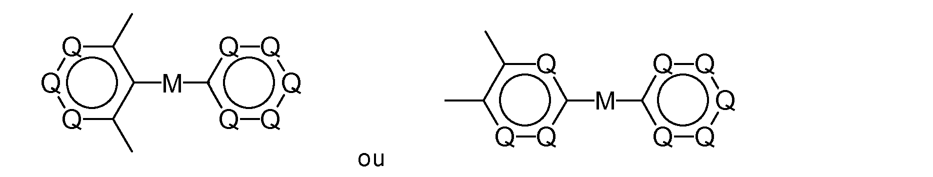 avec Q = C-A ou N,
avec A = H, F, (CH₂)ₚCH₃, (CF₂)ₚCF₃, O(CH₂)ₚCH₃, O(CF₂)ₚCF₃, CO(CH₂)ₚCH₃, CO(CF₂)ₚCF₃ avec p = 0 à 8 (chaîne linéaire ou ramifiée), OC(CH₃)₃, OC(CF₃)₃, C₆H₅, C₆F₅, OC₆H₅, OC₆F₅, cyclopentyle, perfluorcyclopentyle, cyclohexyle ou perfluorcyclohexyle,
où, dans les cycles aromatiques isolés, au maximum 3 atomes de N par cycle doivent être présents et seulement 2 atomes de N peuvent être voisins et, dans les systèmes cycliques condensés, au maximum 2 atomes de N par cycle doivent être présents, ou Z est 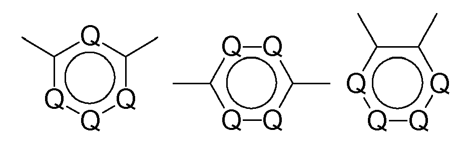 avec Q = C-A ou N,
avec A = F, (CH₂)ₚCH₃, (CF₂)ₚCF₃, O(CH₂)ₚCH₃, O(CF₂)ₚCF₃, CO(CH₂)ₚCH₃, CO(CF₂)ₚCF₃ avec p = 0 à 8 (chaîne linéaire ou ramifiée), OC(CH₃)₃, OC(CF₃)₃, C₆H₅, C₆F₅, OC₆H₅, OC₆F₅, cyclopentyle, perfluorcyclopentyle, cyclohexyle ou perfluorcyclohexyle,
où au maximum 3 atomes de N par cycle doivent être présents et seulement 2 atomes de N peuvent être voisins,
M = une liaison simple, un groupe d'alkyles à chaîne droite, un groupe d'alkyles perfluoré à chaîne droite, CH(CH₃), CH(CF₃), CF(CH₃), CF(CF₃), C(CH₃)₂, C(CF₃)₂, CH(C₆H₅), CH(C₆F₅), CF(C₆H₅), CF(C₆F₅),
C(CH₃) (C₆H₅), C(CH₃) (C₆F₅), C(CF₃) (C₆H₅), C(CF₃) (C₆F₅), C(C₆H₅)₂, C (C₆F₅)₂, CO, SO₂, 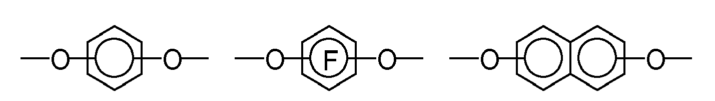 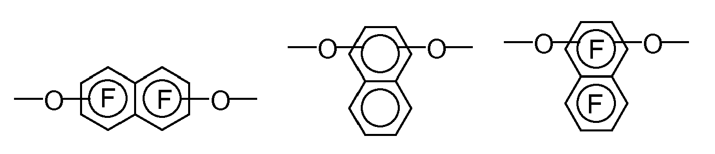 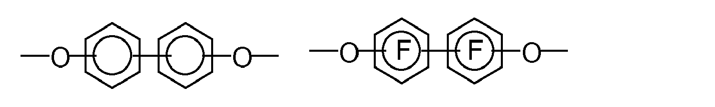 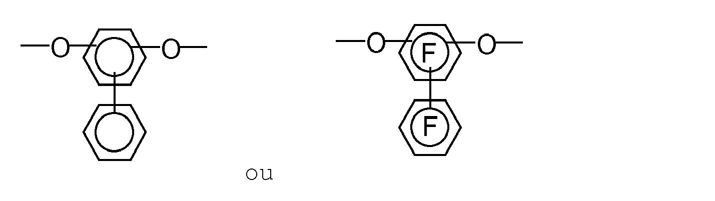 à la condition que si Z = phénylène, au moins un des restes A¹ à A⁷ doit être ≠H.

2. Solutions de photorésist, **caractérisées en ce qu**' elles contiennent un précurseur de polybenzoxazole ou de polybenzothiazole selon la revendication 1 et un diazocétone comme composants photoactifs, dissous dans un solvant organique.

3. Solutions de photorésist selon la revendication 2, **c aractérisées en ce que** le rapport pondéral du précurseur de polybenzoxazole ou de polybenzothiazole à la diazoquinone comme diazocétone est compris entre 1:20 et 20:1, de préférence entre 1:10 et 10:1.
